## Europäisches Patentamt
## European Patent Office
## Office européen des brevets

(11) Publication number: **0 217 156**
**A1**

(12) **EUROPEAN PATENT APPLICATION**

(21) Application number: **86112125.9**

(22) Date of filing: **02.09.86**

(51) Int. Cl.⁴: **C 25 D 17/10**

(30) Priority: **03.09.85 JP 135489/85 U**

(43) Date of publication of application:
**08.04.87 Bulletin 87/15**

(84) Designated Contracting States:
**DE FR GB**

(71) Applicant: **SUMITOMO ELECTRIC INDUSTRIES LIMITED**
**No. 15, Kitahama 5-chome Higashi-ku**
**Osaka-shi Osaka 541(JP)**

(72) Inventor: **Yamamoto, Susumu c/o Itami Works**
**Sumitomo Elec.Ind.Ltd.No.1-1, Koyakita 1-chome**
**Itami-shi Hyogo(JP)**

(74) Representative: **Patentanwälte Grünecker, Kinkeldey,**
**Stockmair & Partner**
**Maximilianstrasse 58**
**D-8000 München 22(DE)**

(54) Electrically conductive member for plating and electrolyzing.

(57) An electrically conductive member to be used for plating or electrolyzing of a core material (1) of a copper group surrounded by a stainless steel coating (2). The stainless steel coating is of thickness equal to or greater than 0.2 mm and the conductive member is shaped such that a ratio $S_s/S_t$ is less than or equal to 0.9, where $S_s$ is the cross-sectional area of the coating material, and $S_t$ is the cross-sectional area of the core material and coating material.

FIG. 1A

FIG. 1B

FIG. 1C

0217156

## ELECTRICALLY CONDUCTIVE MEMBER
## FOR PLATING AND ELECTROLYZING

## BACKGROUND OF THE INVENTION

### Field of the Invention

The present invention relates to an electrically conductive member to be used for plating or electrolyzing.

### Description of the Prior Art

Copper and stainless steel have been widely used in the plating or electrolytic industries as electrically conductive members, such as plating frames, crosspieces fitted in the plating frames, current conducting bars, carrier bars, anode bars, and electrodes. However, where copper is used as a current conducting frame it is not only insufficient in its anti-corrosion properties, but is apt to be unnecessarily plated by an amount equal to or more than the object to be plated.

Likewise, the use of stainless steel as an electrically conducting member has drawbacks in practice. Stainless steel has poor electric conductivity causing unnecessarily larger power usage. It is therefore necessary to make a stainless steel current conducting member of greater size to reduce resistance. Such a member, however, generates a great deal of heat when used, causing process control problems and problems caused by acids contained in the plating liquid humidity surrounding the electrode during the plating operation.

Thus because of the poor anti-corrosion properties of copper cores, a corrosion would occur in the plating liquid humidity containing acids, further, rapid corrosion occurs when the core is placed in the plating liquid. Also, due to a lack of structural strength, when copper is used as a large scale current conducting frame, it often becomes curved as a result of its own weight. The use of copper may also result in a large amount of unnecessary copper plating. Where stainless steel is used as an electrically conductive member it is necessary to apply a high voltage, and may be necessary to use a conducting member of large cross-sectional area. Also much heat is generated, so that a large amount of copper plating is performed unnecessarily. Finally, a large current is required. These shortcomings result from the low conductivity of stainless steel.

## SUMMARY OF THE INVENTION

It is therefore an object of the present invention to overcome the corrosion, unnecessary plating, and weakness problems of copper conductors, as well as the low conductivity problems of stainless steel.

In order to attain this object, the present invention provides an electrically conductive member for plating and electrolyzing which comprises a core material of a copper group selected from copper, bronze and brass or like alloys, a coating material of stainless steel formed on the outer periphery of the core material, the coating material having a thickness equal to or greater than 0.2 mm. Further, in order to achieve most improved conductivity according to the present invention and for ease of production, the conductive member must have ratio of $S_S/S_t$ of less than or equal to 0.9, where $S_S$ is the cross-sectional area of the coating material, and $S_t$ is the total cross-sectional area of the core material and coating material.

## BRIEF DESCRIPTION OF THE DRAWINGS

Figs. 1A, 1B, and 1C are perspective cross-sections of various conducting members according to the present invention; and

Fig. 2 is a front view of a plating frame for explaining the embodiments of the conducting member according to the present invention.

## DETAILED DESCRIPTION OF PREFERRED EMBODIMENTS

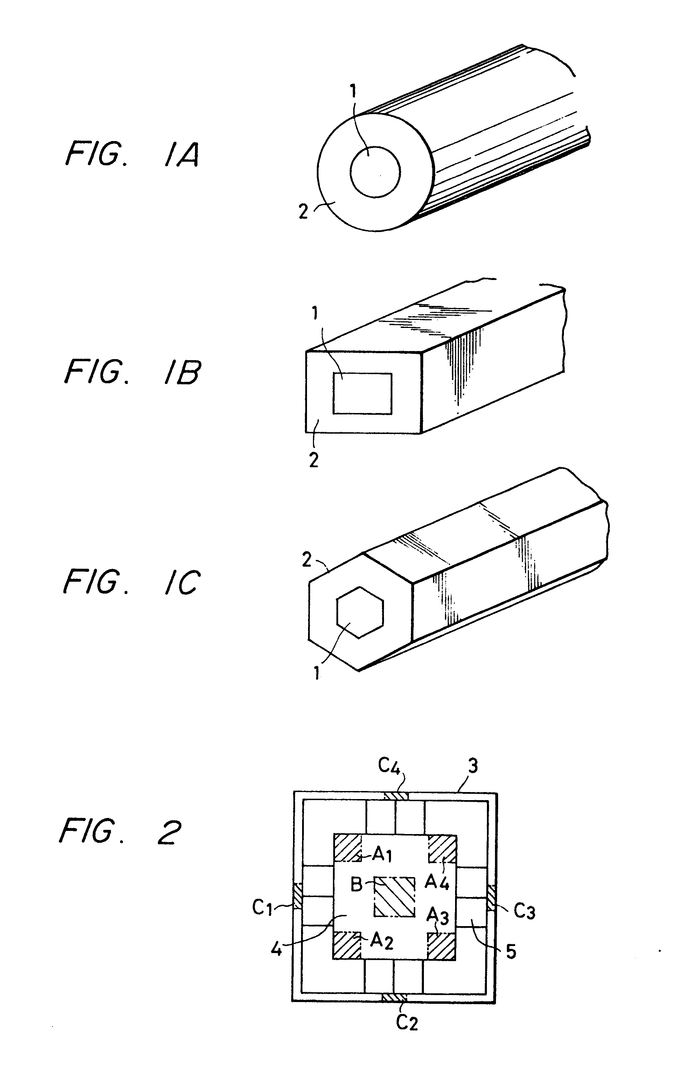

Referring to Figures 1 and 2, the present invention will now be described in detail.

As shown in each of Figs. 1A, 1B and 1C, the electrically conductive member for plating and electrolyzing according to the present invention is a composite member having a core material of a copper group 1, and a coating material 2 of stainless steel formed on the outer periphery of core material 1. The electrically conductive member can be a rod-like, or linear, having, for example, a circular cross-section as shown in Fig. 1A, or a square or polygonal cross-section as shown in Figs. 1B or 1C, respectively.

The thickness of stainless steel coating material 2 is selected to be greater than or equal to 0.2 mm. If the thickness is less than 0.2 mm, the coating material 2 may be broken by an external force such as that core material 1 may be exposed in welding or in machining.

The ratio $S_s/S_t$ is selected to be less than or equal to 0.9, where $S_s$ is the cross-sectional area of the stainless steel coating material 2, and $S_t$ is the total cross-sectional area of the core material of the copper group 1 and coating material 2, that is, $S_t$ is the total cross-sectional area of the electrically conductive member.

If the ratio $S_s/S_t$ exceeds 0.9, the improvement in conductivity achieved by the present invention is not as pronounced, and the conductive member is not easily produced. The core material may be a copper containing metal such as brass or bronze, and the like, besides copper itself.

The end surfaces of the bar-like or linear conductive members may be provided padding with stainless steel by welding or the like so that the core material of copper group is not exposed. In this manner, high conductivity is provided by the core material of copper material, while strength, corrosion resistance and heat resistance are provided by the coating material of stainless steel.

### EXAMPLES

Examples will now be described for a better understanding of the present invention.

Example I: Current conducting bar (for Ni plating)

For a comparative example, a copper bar having a cross-section of 20 x 40 mm was used for nickel plating. According to the present invention, a composite bar having a cross-section of 20 x 40 mm and composed of a core of copper and an outer coating of stainless steel (SUS 304) was used. An outer coating thickness of 0.4 mm was used, along with an $S_s/S_t$ ratio of 0.06. The plating solution used was a mixed liquid of nickel (II) sulfate, nickel (II) chloride and hydrogen chloride.

In each the comparative example and example according to the present invention, the conducting members could be properly plated. However, the bar of the comparative example started to rust four days after plating because of the presence of acids and contaminants in the plating liquid, while the bar according to the present invention did not start to rust even sixty days after plating.

Example II: Plating Frame

As shown in Table 1, a composite conductive member composed of a copper core and an SUS 304 outer coating according to the present invention was prepared as a plating frame for plating a printed circuit board in piece of a stainless steel frame. As comparative examples, SUS 303 and copper bars were prepared.

Table 1

| Sample | Side Length | Conductivity | Tensile strength |
|---|---|---|---|
| Composite bar of the present invention | 15mm | 37% IACS | $95kg/mm^2$ |
| SUS 304 Bar | 15mm | 2.2% IACS | $112kg/mm^2$ |
| Copper bar | 15mm | 95% IACS | $35kg/mm^2$ |
| Copper bar + insulating film | 15mm | | |

It may be noted that for the purposes of the data shown in Table 1, the composite conductive member of the present invention had a thickness of the outer coating of SUS 304 of 3 mm and the ratio $S_s/S_t$ was 0.64.

Four frames of 1000 mm X 1000 mm were made of the four kinds of the bars described in Table 1 respectively. A printed circuit board (900mm X 900mm) having copper foils attached on the opposite surfaces thereof was fixed in each of the four frames and copper-plated for thirty minutes in a solution of copper pyrophosphate. The current was fixed at 1000 amps.

Referring to Fig. 2, an evaluation of quality and characteristics of each type of plating frame was effected as to the average film thickness at corner portions ($A_1$, $A_2$, $A_3$, and $A_4$) of the printed circuit board, the film thickness at a

0217156

central portion (B) and the average film thickness at central portions ($C_1$, $C_2$, $C_3$, and $C_4$) of the plating frame. In Fig. 2 reference numeral 3 designates the plating frame, numeral 4 designates the printed circuit board, and numeral 5 the clips. The results are shown in Table 2.

The thickness of the film at each of the portions $A_1$ to $A_4$ and B was obtained by subtracting the film thickness of the copper foil from the film thickness after plating at the respective portion. The measurement was taken at the area of 100 X 100 mm (length X width) at each of the portions $A_1$ to $A_4$ and B at the surfaces thereof, and at portions $C_1$ to $C_4$.

Table 2

| Kind of Plating Frame / Portions | Film thickness at A1 to A4 | Film thickness at B | Film Thickness at C1 to C4 |
|---|---|---|---|
| Composite bar of Cu-core and SUS 304 coating | 40 microns | 39 microns | 1.2 microns |
| SUS 304 bar | 38 microns | 36 microns | 13 microns |
| Copper bar | 35 microns | 34 microns | 51 microns |
| Copper bar coated with insulating film | 43 microns | 38 microns | 0 micron |

The results as set forth in Table 2 show that:

The composite bar of a copper core and a SUS 304 outer coating is the most superior in that the plated portions on the printed circuit board are uniform in thickness, the current efficiency is good, and little excessive plated copper adhered to the plating frame.

In the case of the SUS 304 bar, the plated portions on the printed circuit board are uniform in thickness, however, heat is generated because of large electric resistance of the SUS bar of the plating frame, so that the amount of copper attached to the plating frame becomes large and therefore the amount of copper attached on the printed circuit board is increased correspondingly.

In the case of the copper bar, the plated portions on the printed circuit board are uniform in thickness, however, the current efficiency on the printed circuit board is lowered because a large quantity of copper is deposited on the plating frame.

The copper bar coated with insulating film is the most superior among all samples in current efficiency since no copper is plated onto the plating frame, however, lack of uniformity in thickness is remarkable at portions $A_1$ to $A_4$ and B.

Necessary characteristics of the plating frame are that the thickness of plating is uniform on the printed circuit board; the current efficiency is large; and the attachment of copper onto the plating frame is minimized.

Based on these data it can be said that the composite conductive member of a copper material core with an SUS 304 coating is an ideal material
for a plating frame.

Copper which has unnecessarily adhered to
the plating frame as described above is generally
removed by acid-treatment or electrolysis so as to
be used again. Accordingly, not only excessive acid
or electricity is required for prior art conductors,
but disposing the waste acid is costly. Further, in
the case of the copper bar coated with insulating
film, although copper does not adhere to the
portions $C_1$ to $C_4$ of the frame, the insulating film
is not effective when the copper bar is subjected to
electrolytic plating as pretreatment for through-
hole plating or the like.

Example III:   Crosspieces fitted in the plating
                frame

When the size of a printed circuit board to
be subjected to copper plating is small in Example
II described above, the plating frame is sectioned
by crosspieces so that printed circuit boards are
set in the respective sections. In the case where
4 x 10 mm SUS 304 crosspieces were used in the SUS
304 plating frame, 7 microns of copper was used.
When the SUS 304 crosspieces were replaced by 5 X 10
mm cross-pieces of composite conductive material of
a copper core with an SUS 304 coating (The thickness
of SUS 304 coating:  2 mm; $S_s/S_t=0.12$), the amount
of attached copper decreased to 0.8 microns.

As discussed above, when a conductive
member having a core material of copper or copper
alloy is used, the conductivity is high. When an
outer coating made of stainless steel is also used,
the corrosion resistance is superior, the strength is high, and the member has improved heat resisting properties.

Those skilled in the art will recognize that modifications and variations of the present invention are possible while retaining the novel features and advantages of the present invention. Accordingly, all such variations and modification are intended to be included in the scope of the appended claims.

0217156

What is Claimed is:

1. An electrically conductive member for plating and electrolyzing comprising a core material of a copper group and a coating material of stainless steel formed on the outer periphery of said core material, said coating material having a thickness greater than or equal to 0.2 mm, and said member being shaped such that the ratio of $S_s/S_t$ is less than or equal to 0.9, where $S_s$ is the cross-sectional area of said coating material and where $S_t$ is the total cross-sectional area of said electrically conductive member.

2. An electrically conductive member as claimed in claim 1 wherein said core material is chosen from the group consisting of copper, bronze, and brass.

3. An electrically conductive member as claimed in claim 1, wherein the member is bar-like and has a cross-sectional shape which is circular, rectangular, polygonal or hollow.

4. An electrically conductive member as claimed in claim 3, wherein the end surfaces of said member are provided with stainless steel padding such that said core is not exposed.

FIG. IA

FIG. IB

FIG. IC

FIG. 2

European Patent
Office

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| X | US-A-4 484 996 (BONGARTZ) <br> * Column 2, lines 46-55 * <br><br> ----- | 1-4 | C 25 D 17/10 |

TECHNICAL FIELDS
SEARCHED (Int Cl.4)

C 25 D

The present search report has been drawn up for all claims

| Place of search | Date of completion of the search | Examiner |
|---|---|---|
| THE HAGUE | 17-12-1986 | NGUYEN THE NGHIEP |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82